# EUROPEAN PATENT APPLICATION

(11) **EP 1 938 970 A1**
(43) Date of publication of application: **02.07.2008**
(21) Application number: 06810764.8
(22) Date of filing: 28.09.2006
(51) Int. Cl.: B41C 1/02, B41N 1/20, B41N 1/22, C23C 14/06, C23C 28/00

(54) **PHOTOGRAVURE ENGRAVING ROLL AND PRODUCTION METHOD THEREOF**

(30) Priority: 30.09.2005 JP 2005288223
(71) Applicant: THINK LABORATORY CO., LTD., Chiba, 227-8525 (JP)
(72) Inventor: SHIGETA, Tatsuo, Kashiwa-shi, Chiba 277-8525 (JP); SATO, Tsutomu, Kashiwa-shi, Chiba 277-8525 (JP); SUGIYAMA, Koichi, Yokohama-shi, Kanagawa 220-8109 (JP); ASANO, Takayuki, Tokyo 146-0093 (JP)
(74) Representative: Grünecker, Kinkeldey, Stockmair & Schwanhäusser Anwaltssozietät
(86) International application number: PCT/JP2006/319317
(87) International publication number: WO 2007/040141

(57) **Abstract**

The present invention provides: a novel gravure printing roll capable of improving plate fogging, being provided with a surface-reinforcing coating layer completely free from toxicity and the possibility of pollution, and of being excellent in printing durability; and a method of producing the roll. The gravure printing roll includes a metal hollow roll, a copper-plated layer provided on the surface of the hollow roll and formed with multiple gravure cells on the surface thereof, a metal layer provided on the surface of the copper-plated layer, a metal carbide gradient layer of the metal provided on the surface of the metal layer, and a diamond-like carbon film covering the surface of the metal carbide gradient layer, in which a pit being smaller than the minimum gravure cell in the highlighted portion of the copper-plated layer and having a size not permitting ink transfer is arranged so that at least one pit exists in the one-pitch area of a screen line in a non-image area.

## Description

### Technical Field

The present invention relates to a gravure printing roll which can reduce plate fogging and to which a surface-reinforcing coating layer having sufficient strength without using chromium plating can be provided, and a method of producing the same. More particularly, the present invention relates to a gravure printing roll, in which a diamond-like carbon (DLC) film is provided as a surface-reinforcing coating layer in place of a chromium layer, and a method of producing the same.

### Background Art

In gravure platemaking, minute concave portions (gravure cells) according to platemaking information are formed in a gravure printing roll (a gravure cylinder) to produce a printing plate, and ink is placed in the gravure cells, thereby transferring an image to a printing target. In a general gravure printing roll, a copper-plated layer (a printing material) for forming a printing plate is formed on the surface of a hollow roll formed of metal such as aluminum and iron, or reinforced resin such as carbon fiber-reinforced plastics (CFRP); many minute concave portions (gravure cells) are formed according to platemaking information in the copper-plated layer by etching; and then a hard chromium layer is formed by chromium plating for increasing the printing durability of a gravure printing roll to obtain a surface-reinforcing coating layer, whereby platemaking (production of a printing plate) is completed. However, since hexavalent chromium with high toxicity is used in chromium plating, extra cost is required for maintaining safe operations and a problem of a pollution arises. Therefore, in the present circumstances, development of a surface-reinforcing coating layer in place of a chromium layer is expected.

In contrast, with respect to production of a gravure printing roll (gravure cylinder), a technology of forming a diamond-like carbon (DLC) on a copper-plated layer, in which cells are formed, and using the same as a surface-reinforcing coating layer is known (Patent Documents 1 to 3), and a technology of forming a DLC layer on a copper-plated layer, and then forming cells, thereby producing a printing plate (Patent Document 4) are known. However, there is a problem that the adhesion of the DLC layer with copper is weak, and thus the DLC layer is likely to separate. The applicant of this application already proposes a technology of forming a rubber or resin layer on a hollow roll, forming a diamond-like carbon (DLC) film thereon, followed by forming cells and producing a gravure printing plate (Patent Documents 5 to 7).

Gravure platemaking is sometimes affected by plate fogging, in which printed results appear to be soiled because a small amount of ink adheres to a non-image area (an area where no printing ink adheres to the printing plate). Plate fogging notably appears when the sharpness of a doctor blade is lost by continuous use for an extended time, when a non-image area on the chromium plating of a gravure roll is not uniformly grooved with sandpaper, when the printing rate of a rotary press is too high, or when printing is done with water-based ink.

Plate fogging is caused by the transfer of a small amount of ink that has passed by the doctor to a non-image area of the printing plate before the ink dries. When the ink that results in plate fogging in a non-image area of the printing plate is a large amount, it means that the plate fogging is caused by the dulling of the doctor blade, which deteriorates the ink-scraping capability of the doctor blade, or by a printing plate with an excessively mirror-like condition, which lowers the self-lubrication property of the printing plate, causing the doctor blade to come into direct contact with the roll surface, thus slightly vibrating the doctor blade and allowing ink to pass through. Therefore, plate fogging is generally resolved by exchanging doctor blades or slightly roughening the roll with sandpaper.

In contrast, the plate fogging that notably appears when printing is done using water-based ink is caused by the fact that water and a small amount of alcohol are used as an ink solvent, and the volatility rate of this solvent is lower than that of toluene. The printing rate when using water-based ink with a rotary press is lowered by about 20% compared to the printing rate when using oil-based ink.
Patent Document 1: JP 04-282296 A
Patent Document 2: JP 2002-172752 A
Patent Document 3: JP 2000-10300 A
Patent Document 4: JP 2002-178653 A
Patent Document 5: JP 11-309950 A
Patent Document 6: JP 11-327124 A
Patent Document 7: JP 2000-15770 A
Patent Document 8: JP 2003-145952 A

### Disclosure of the Invention

### Problems to be Solved by the Invention

From the viewpoint of global warming prevention, it is requested to use water-based ink in place of oil-based ink containing about 50% of toluene which causes the discharge of carbon dioxide. Therefore, some improvements such as improvements in water-based ink, doctor blades, and gravure printing rolls, are demanded so that plate fogging does not occur even when the printing rate in the case of using water-based ink is made substantially equivalent to the printing rate in the case of using oil-based ink.

One of the inventors of the present invention focused attention on the fact that plate fogging is reduced by minutely roughing a roll with sandpaper, and carried out extensive researches. Then, the inventor already confirmed that plate fogging did not occur when printing was performed using water-based ink by forming cells of 3.5 µm x 7.0 µm in a non-image area.

Then, a novel gravure printing roll and a novel method for producing a gravure printing roll are accomplished based on a finding that when a non-image area is minutely roughened so that ink does not transfer and a roll is minutely roughened with sandpaper, plate fogging is less likely to occur even when the printing rate in the case of using water-based ink is made substantially equivalent to the printing rate in the case of using oil-based ink. The novel gravure printing roll and the novel method for producing a gravure printing roll were already proposed (Patent Document 8).

In contrast, the inventors of the present invention continued extensive researches on a surface-reinforcing coating layer in place of a chromium layer and found that a surface-reinforcing coating layer which has strength comparable to a chromium layer, does not have toxicity, and is free from the anxiety of pollution can be obtained by the combined use of a metal layer, a metal carbide layer, and a diamond-like carbon (DLC) film.

The present invention aims to provide a novel gravure printing roll which can reduce plate fogging, has no toxicity, is free from the anxiety of pollution, has a surface-reinforcing coating layer, and is excellent in printing durability, and a method of producing the same.

### Means for Solving the Problems

According to the present invention, a gravure printing roll includes: a hollow roll; a copper-plated layer formed on a surface of the hollow roll and having multiple gravure cells formed on a surface of the copper-plated layer; a metal layer formed on the surface of the copper-plated layer; a metal carbide layer of the metal formed on a surface of the metal layer; and a diamond-like carbon film covering a surface of the metal carbide layer, in which pits whose sizes are smaller than a minimum gravure cell in a highlighted portion of the copper-plated layer and does not permit transfer of ink are arranged so that at least one pit exists in a one-pitch area of a screen line in a non-image area.

According to the present invention, a method of producing a gravure printing roll includes the steps of: preparing a hollow roll; forming a copper-plated layer on a surface of the hollow roll; forming multiple gravure cells and pits on a surface of the copper-plated layer; forming a metal layer on the surface of the copper-plated layer; forming a metal carbide layer of the metal on a surface of the metal layer; and forming a diamond-like carbon film on a surface of the metal carbide layer, wherein pits whose sizes are smaller than a minimum gravure cell in a highlighted portion of the copper-plated layer and does not permit transfer of ink are arranged so that at least one pit exists in a one-pitch area of a screen line in a non-image area during the formation of the gravure cells and the pits.

It is preferred that the metal carbide layer be a metal carbide gradient layer, and a composition ratio of carbon in the metal carbide gradient layer be set so that a proportion of carbon increases gradually in a direction of the diamond-like carbon film from the metal layer side.

It is preferred that a thickness of the copper-plated layer be 50 to 200 µm, a depth of the gravure cells be 5 to 150 µm, a thickness of the metal layer be 0.001 to 1 µm, preferably 0.001 to 0.1 µm, and more preferably 0.001 to 0.05 µm, a thickness of the metal carbide layer be 0.1 to 1 µm, and a thickness of the diamond-like carbon film be preferably 0.1 to 10 µm.

It is preferred that the metal layer, the metal carbide layer, preferably, the metal carbide gradient layer and the diamond-like carbon film be formed by sputtering, respectively.

It is preferred that the metal be capable of being carbonated and has high compatibility with copper.

It is preferred that the metal be one kind or at least two kinds of metals selected from the group consisting of tungsten (W), silicon (Si), titanium (Ti), chromium (Cr), tantalum (Ta), and zirconium (Zr).

It is preferred that the gravure cells and pits be preferably formed by etching or electronic platemaking.

Preferably, synthetic digital information in which digital information of formation patterns of the gravure cells and digital information of arrangement patterns of the pits are superimposed is made, and the gravure cells and pits are formed based on the superimposed synthetic digital information.

### Effects of the Invention

According to the gravure printing roll of the present invention, ink which has passed a doctor blade enters countless minute cells formed in a non-image area according to the capillary phenomenon, thereby reducing plate fogging. When a roll is minutely roughened with sandpaper in addition to the above, plate fogging is sharply reduced. The plate fogging does not occur even when the printing rate in the case of using water-based ink is made substantially equivalent to the printing rate in the case of using oil-based ink.

According to the method of producing a gravure printing roll of the present invention, the gravure printing roll of the present invention can be favorably made, and the above-mentioned effects are acquired. Moreover, according to the present invention, by the use of the diamond-like carbon (DLC) film as a surface-reinforcing coating layer, a chromium plating process can be omitted, which eliminates the necessity of using hexavalent chromium with high toxicity and incurs no extra cost for safe operations. Moreover, the present invention is completely free from the anxiety of pollution, and exhibits excellent effects that the diamond-like carbon (DLC) film has strength comparable to that of a chromium layer and is excellent in the printing durability.

### Brief Description of the Drawings

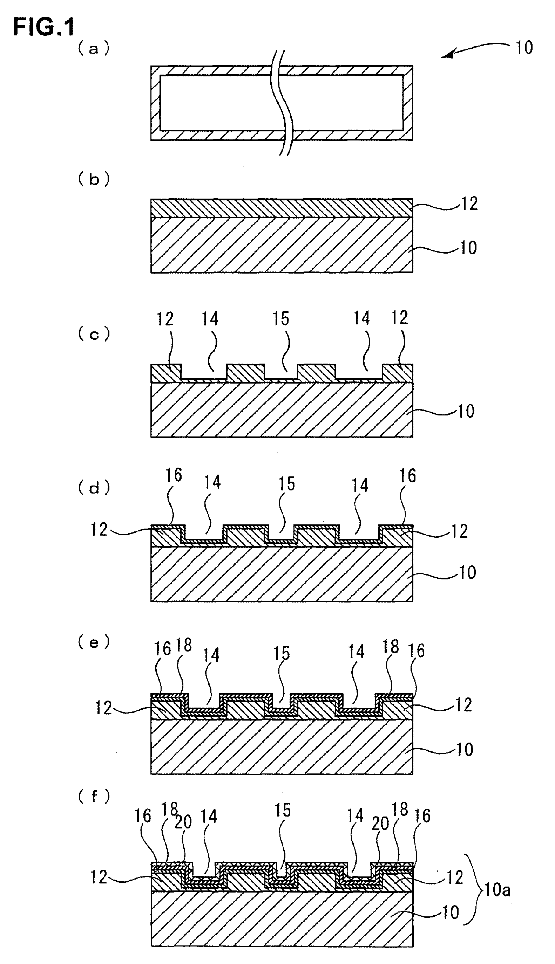

FIG. 1 is an explanatory diagram schematically illustrating a process of producing a gravure printing roll of the present invention, in which: the part (a) is an entire cross-sectional view of a hollow roll; the part (b) is a partial enlarged cross-sectional view illustrating a state in which a copper-plated layer is formed on the surface of the hollow roll; the part (c) is a partial enlarged cross-sectional view illustrating a state in which gravure cells are formed on the copper-plated layer of the hollow roll; the part (d) is a partial enlarged cross-sectional view illustrating a state in which a metal layer is formed on the surface of the copper-plated layer of the hollow roll; the part (e) is a partial enlarged cross-sectional view illustrating a state in which a metal carbide layer is formed on the surface of the metal layer of the hollow roll; and part (f) is a partial enlarged cross-sectional view illustrating a state in which a diamond-like carbon (DLC) film covers the surface of the metal carbide layer of the hollow roll.
FIG. 2 is a flowchart illustrating a method of producing a gravure printing roll of the present invention.
FIG. 3 is an enlarged cross-sectional view of main portions of the gravure printing roll of the present invention.
FIG. 4 is an enlarged cross-sectional view illustrating a laminated state of each layer of the gravure printing roll of the present invention.

### Description of Symbols

10: a plate base material (a hollow roll), 10a: a gravure printing roll, 12: a copper-plated layer, 14: a gravure cell, 14a: a minimum gravure cell, 15: a pit, 16: a metal layer, 18: a metal carbide layer, preferably, a metal carbide gradient layer, 20: a diamond-like carbon (DLC) film

### Best Mode for Carrying out the Invention

Hereinafter, an embodiment of the present invention will be described. Illustrated examples are shown for illustrative purposes and, it goes without saying that they can be modified variously as long as they do not extend beyond the technical idea of the present invention.

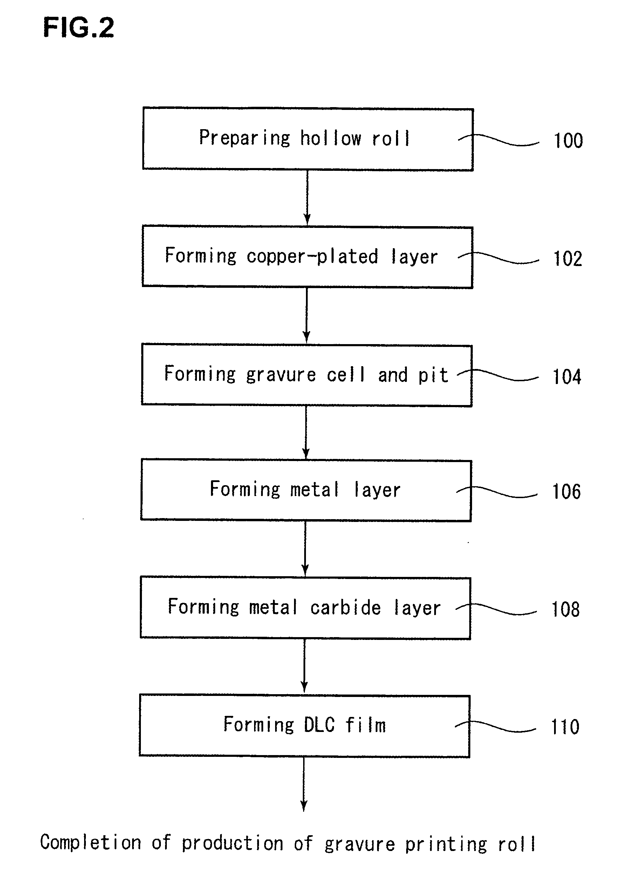

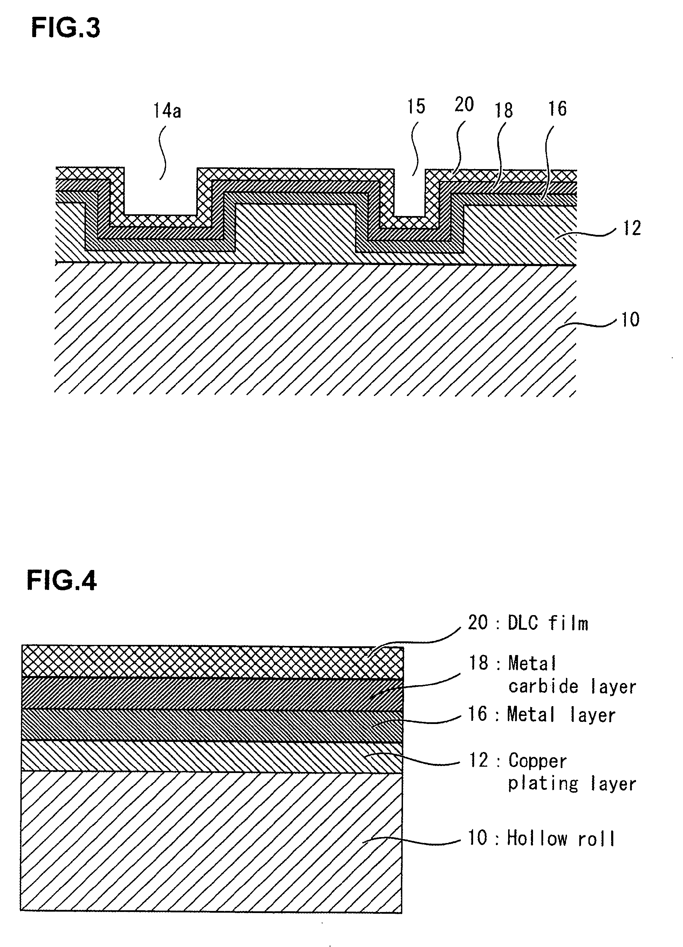

FIG. 1 is an explanatory diagram schematically illustrating a production process of a gravure printing roll of the present invention: (a) is an entire cross-sectional view of a hollow roll; (b) is a partial enlarged cross-sectional view illustrating a state in which a copper-plated layer is formed on the surface of the hollow roll; (c) is a partial enlarged cross-sectional view illustrating a state in which gravure cells and pits are formed on the copper-plated layer of the hollow roll; (d) is a partial enlarged cross-sectional view illustrating a state in which a metal layer is formed on the surface of the copper-plated layer of the hollow roll; (e) is a partial enlarged cross-sectional view illustrating a state in which a metal carbide layer is formed on the surface of the metal layer of the hollow roll; and (f) is a partial enlarged cross-sectional view illustrating a state in which a diamond-like carbon (DLC) film covers the surface of the metal carbide layer of the hollow roll. FIG. 2 is a flowchart illustrating a method of producing a gravure printing roll of the present invention. FIG. 3 is an enlarged cross-sectional view of main portions of the gravure printing roll of the present invention. FIG. 4 is an enlarged cross-sectional view illustrating a laminated state of each layer of the gravure printing roll of the present invention.

The method of the present invention will be described with reference to FIGS. 1 to 4. In FIGS. 1(a), 3, and 4, reference numeral 10 denotes a plate base material, and a hollow roll made of a metal such as aluminum or iron, or a reinforced resin such as carbon fiber-reinforced plastic (CFRP) is used (Step 100 of FIG. 2). A copper-plated layer 12 is formed on the surface of the hollow roll 10 by copper plating (Step 102 of FIG. 2).

On the surface of the copper-plated layer 12, a number of minute concave portions (gravure cells) 14 and pits 15 are formed (Step 104 of FIG. 2). As a method of forming the gravure cells 14, a known method can be used, such as etching (coating a plate cylinder surface with a sensitizing solution to perform direct burning, followed by etching, thereby forming the gravure cells 14) or electronic platemaking where a diamond platemaking needle is mechanically operated with a digital signal to make the gravure cells 14 on the copper surface, and etching is preferable.

Next, on the surface of the copper-plated layer 12 (including the gravure cells 14) with the gravure cells 14 formed thereon, a metal layer 16 is formed (Step 106 of FIG. 2). Further, a metal carbide layer of the metal, preferably, a metal carbide gradient layer 18 is formed on the surface of the metal layer 16 (Step 108 of FIG. 2). As a method of forming the metal layer 16 and the metal carbide layer, preferably, the metal carbide gradient layer 18, known methods such as a sputtering method, a vacuum deposition method (an electron beam method), an ion plating method, a molecular beam epitaxy (MBE) method, a laser abrasion method, an ion assist film-formation method, or a plasma CVD method can be applied, and the sputtering method is preferable.

As the metal, a metal capable of being carbonated and having high compatibility with copper is preferable. As the metal, it is possible to use tungsten (W), silicon (Si), titanium (Ti), chromium (Cr), tantalum (Ta), and zirconium (Zr).

As the metal in the metal carbide layer, preferably, the metal carbide gradient layer 18, the same metal as that of the metal layer 16 is used. The composition ratio of carbon in the metal carbide gradient layer 18 is set so that the proportion of carbon increases gradually from the metal layer 16 side in the direction of a diamond-like carbon (DLC) film 20 described later. That is, film formation is performed so that the composition ratio of carbon increases gradually in a proportion from 0% (by stages or by non-stages) to finally reach about 100%.

In this case, as a method of adjusting the composition ratio of carbon in the metal carbide layer, preferably, the metal carbide gradient layer 18, a known method may be used. For example, the metal carbide layer (i.e., the metal carbide gradient layer 18) can be formed, in which the composition ratios of carbon and metal are changed so that the proportion of carbon in the metal carbide layer 18 increases gradually by stages or by non-stages in the direction of the diamond-like carbon (DLC) film 20 from the copper-plated layer 12 side, for example, by sputtering wherein the injection amount of hydrocarbon gas such as methane gas, ethane gas, propane gas, butane gas, or acetylene gas increases gradually by stages or by non-stages in an argon gas atmosphere, using a solid metal target.

By adjusting the proportion of carbon in the metal carbide layer 18, the adhesion of the metal carbide layer 18 with respect to both the copper-plated layer 12 and the diamond-like carbon (DLC) film 20 can be enhanced. Further, if the injection amount of hydrocarbon gas is set to be constant, a metal carbide layer in which the composition ratios of carbon and metal are set to be constant can be formed, and the metal carbide layer thus obtained is allowed to function similarly to that of the metal carbide gradient layer.

Then, on the surface of the metal carbide layer, preferably, of the metal carbide gradient layer 18, the diamond-like carbon (DLC) film 20 is formed so as to cover the surface of the metal carbide layer (Step 110 of FIG. 2). As a method of forming the diamond-like carbon (DLC) film 20, in the same way as in the formation of the metal layer 16 and the metal carbide layer, preferably, the metal carbide gradient layer 18, a known method such as a sputtering method, a vacuum deposition method (an electron beam method), an ion plating method, a molecular beam epitaxy (MBE) method, a laser abrasion method, an ion assist film formation method, or a plasma CVD method can be applied, and the sputtering method is preferable.

The above-mentioned diamond-like carbon (DLC) film 20 is covered, and is allowed to function as a surface-reinforcing coating layer, whereby a gravure printing roll 10a excellent in printing durability without toxicity and any possibility of the occurrence of pollution can be obtained.

Herein, according to the sputtering method, ions are allowed to collide against a material (target material) to be a thin film, the material is sputtered, and the sputtered material is deposited on a substrate to produce a thin film. Sputtering is characterized for example, in that particular limitations are not imposed on a target material, and a thin film can be produced with good reproducibility in a large area.

According to the vacuum deposition method (the electron beam method), a material to be a thin film is heated to be evaporated by the irradiation of electron beams, and the evaporated material adheres (is deposited) on a substrate to produce a thin film. The vacuum deposition method is characterized, for example, in that a film formation speed is high, and the damage to a substrate is small.

According to the ion plating method, a material to be a thin film is evaporated and ionized with a radio frequency (RF) (an RF ion plating method) or an arc (an arc ion plating method), and deposited on a substrate to produce a thin film. The ion plating method is characterized, for example, in that a film formation speed is high, and adhesion strength is large.

The molecular beam epitaxy method is a method of evaporating a raw material in an ultrasonic vacuum, and supplying the raw material to a heated substrate to form a thin film.

The laser abrasion method is a method of allowing a laser pulse increased in density to be incident upon a target to allow ions to be released, thereby forming a thin film on an opposed substrate.

The ion assist film formation method is a method of setting an evaporation source and an ion source in a vacuum container, and forming a film, using ions, supplementarily.

The plasma CVD method is a method of decomposing a material gas using the excitation of plasma, and allowing the material gas to be deposited by reaction on a substrate, for the purpose of forming a thin film at lower temperature when performing a CVD method under a reduced pressure.

FIG. 3 is an enlarged cross-sectional view of main portions of the gravure printing roll of the present invention. Reference numeral 14a denotes a minimum gravure cell in a highlighted portion (in the case of circular shape, 30 µm in diameter with oil-based ink and 15 µm in diameter with water-based ink), and ink can be transferred. Reference numeral 15 denotes a pit formed in the non-image area. The pit 15 is smaller than the minimum gravure cell 14a in the highlighted portion, and has a size not permitting ink transfer (note: in this specification, concave portions in which ink can be transferred is referred to as gravure cells and concave portions in which ink cannot be transferred is referred to as a different technical term). It suffices that the pits 15 are arranged so that at least one pit exists in the one-pitch area of a screen line. Because the pitch of the gravure cells is predetermined in a usual gravure printing roll, minute pits not permitting transfer of ink which can be formed in a non-image area also follows the arrangement of the gravure cells. The number of minute pits is not limited to one in the one-pitch area of a screen line, and several minute pits can be formed by patterning. The dimension of the pit which is smaller than the minimum gravure cell 14a in the highlighted portion and has a size not permitting transfer of ink is, specifically, for example, 7.0 µm x 7.0 µm.

In platemaking, minute pits not permitting transfer of ink are formed in a non-image area by making synthetic digital information in which digital information of formation patterns of the gravure cells and digital information of arrangement patterns of the pits are superimposed, and exposing based on the synthetic digital information.

The pits are arranged in such a manner that pitches of the pits in the roll circumferential direction are random and the pits do not cut in the same location in the circumferential direction of the screen line, and the ink scraping function of the doctor blade is not impaired.

In the method of producing the gravure printing roll of the present invention, it is preferable to form gravure cells and pits by making the synthetic digital information, based on the synthetic digital information having the superimposed information.

### Example

The present invention will be described more specifically by way of the following examples. It should be appreciated that these examples are shown merely for an illustrative purpose and should not be interpreted in a limiting manner.

### (Example 1)

A gravure cylinder (an aluminum hollow roll) with a circumference of 600 mm and a roll length of 1,100 mm was placed in a plating bath. An anode chamber was brought close to the hollow roll up to 20 mm by an automatic slide apparatus under a computer system to allow a plating solution to overflow to immerse the hollow roll completely, whereby a copper-plated layer of 80 µm was formed at 18 A/dm² and 6.0 V. A plating time was 20 minutes, and no rashes and the like were generated on the surface of plating. Thus, a uniform copper-plated layer was obtained.

The copper-plated layer thus formed was coated with a photosensitive film. An image was exposed to a laser to be developed, followed by burning, thereby forming a resist image. Then, dry etching such as plasma etching was conducted to make an image made of gravure cells and to form pits. After that, a resist image was removed to prepare a hollow roll forming a printing plate.

On an upper surface of the copper-plated layer with the gravure cells and the pits formed thereon, a tungsten (W) layer was formed by sputtering. The sputtering conditions were as follows. A tungsten (W) sample: a solid tungsten target, an atmosphere: an argon gas atmosphere, a film formation temperature: 200 to 300°C, a film formation time: 60 minutes, and a film formation thickness: 0.03 µm.

Next, a tungsten carbide layer was formed on the upper surface of the tungsten layer (W). The sputtering conditions were as follows. A tungsten (W) sample: a solid tungsten target, an atmosphere: hydrocarbon gas was increased gradually in an argon gas atmosphere, a film formation temperature: 200 to 300°C, a film formation time: 60 minutes, and a film formation thickness: 0.1 µm.

A diamond-like carbon (DLC) film was further formed covering the upper face of the tungsten carbide layer by sputtering. The sputtering conditions were as follows. A DLC sample: a solid carbon target, an atmosphere: an argon gas atmosphere, a film formation temperature: 200 to 300°C, a film formation time: 150 minutes, and a film thickness: 1 µm. Thus, the formation of the gravure printing roll (gravure cylinder) was completed. At this time, it was confirmed that the depth of the gravure cell was 10 µm; the minimum gravure cell was circular and had a diameter of 15 µm; and pits of 2 µm x 5 µm were formed in the non-image area. The gravure cylinder was partially roughened minutely with sandpaper.

Water-based ink was applied to the above-mentioned gravure cylinder, and a printing test was performed using Oriented Polypropylene Film (OPP: biaxialy stretched polypropylene film) (printing rate of 200 m/minute, OPP film length of 4,000 m). With respect to the obtained printed substance, no plate fogging occurred in the portion which was minutely roughened with sandpaper, and only slight plate fogging occurred in the portion which was not minutely roughened with sandpaper. Moreover, the ink transferability was excellent. The results confirmed that the diamond-like carbon (DLC) film had performance comparable to that of the conventional chromium layer, and was satisfactorily used as a substitute for a chromium layer.

### (Example 2)

A hollow roll forming gravure cells and pits was produced in the same way as Example 1. A gravure printing roll was completed by treating in the same way as Example 1 except that the tungsten (W) sample was changed to a silicone (Si) sample with respect to the hollow roll. A printing test was conducted in the same way as Example 1. The result was the same as Example 1, that is, no plate fogging occurred in the portion which was minutely roughened with sandpaper, and only slight plate fogging occurred in the portion which was not minutely roughened with sandpaper, and a printed substrate excellent in ink transferability was obtained. In this Example, it was also confirmed that the diamond-like carbon (DLC) film had performance comparable to that of the conventional chromium layer, and was satisfactorily used as a substitute for a chromium layer.

It should be noted that the same experiment was performed using titanium (Ti) and chromium (Cr) as metal samples, and it was confirmed that the same results were obtained.

### (Example 3)

A gradation of 0% to 100% was prepared as plate information prior to forming the plate. Two laser beams were then lined up in the circumferential direction of the roll and irradiation patterns were made with exposure areas measuring 3.5 µm x 7.0 µm at a 140µm pitch in the length direction of the roll, and at a random pitch in the range of 70 µm to 140 µm in the circumferential direction of the roll. Following this, digital information was made by screening the irradiation patterns according to a screening program, and superimposing the digital information for the resulting screens onto the previously described gradation.

Subsequently, a positive photosensitive film (manufactured by Creo Scitex Corporation, Ltd., Canada) was applied to a mirror-finished surface of the copper-plated layer. The photosensitive film was dried in such a manner that the residual solvent became 2% or less. Thereafter, a laser exposure device equipped with laser heads capable of irradiating an infrared laser beam in unit areas of 1.8 µm x 7.0 µm was arranged so that two laser beams each having an output size of 1.8 µm x 7.0 µm were arranged side by side to extend the output in the length direction of the roll, and radiation exposure was conducted in unit areas of 3.5 µm x 7.0 µm and pitches of 28 µm in both the circumferential direction and the length direction of the roll. Subsequently, development, etching, resist separation, formation of tungsten (W) layer, formation of tungsten carbide gradient layer, and formation of diamond-like carbon (DLC) film were performed in this order, thereby making a test sample. The tungsten layer, the tungsten carbide layer, and the DLC film were formed in the same manner as in Example 1. It was confirmed that the test sample had pits of 2.0 µm x 5.0 µm formed in the non-image area. Then, the roll was partially roughened minutely with sandpaper.

When the roll was attached to a gravure rotary press, and printing was performed at a printing rate of 120 m/min using water-based ink, printing with excellent gradation was performed. Pits of 2.0 µm x 5.0 µm were adhered to the gradation cells, but the gray scale degree was not seriously impaired. Plate fogging in the non-image area was sharply reduced. More specifically, no plate fogging occurred in the portion which was minutely roughened with sandpaper, and only slight plate fogging occurred in the portion which was not minutely roughened with sandpaper. The pits of 2.0 µm x 5.0 µm were not cut in the same location in the circumferential direction of the screen, and the ink-scraping function of the doctor was not impaired. In addition, the same results as in Example 1 above were obtained.

## Claims

1. A gravure printing roll, comprising:
a hollow roll;
a copper-plated layer formed on a surface of the hollow roll and having multiple gravure cells formed on a surface of the copper-plated layer;
a metal layer formed on the surface of the copper-plated layer;
a metal carbide layer of the metal formed on a surface of the metal layer; and
a diamond-like carbon film covering a surface of the metal carbide layer, wherein
pits whose sizes are smaller than a minimum gravure cell in a highlighted portion of the copper-plated layer and does not permit transfer of ink are arranged so that at least one pit exists in a one-pitch area of a screen line in a non-image area.

2. A gravure printing roll, wherein the metal carbide layer is a metal carbide gradient layer, and a composition ratio of carbon in the metal carbide gradient layer is set so that a proportion of carbon increases gradually in a direction of the diamond-like carbon film from the metal layer side.

3. A gravure printing roll according to claim 1 or 2, wherein a thickness of the copper-plated layer is 50 to 200 µm, a depth of the gravure cells is 5 to 150 µm, a thickness of the metal layer is 0.001 to 1 µm, a thickness of the metal carbide layer is 0.1 to 1 µm, and a thickness of the diamond-like carbon film is 0.1 to 10 µm.

4. A gravure printing roll according to any one of claims 1 to 3, wherein the metal is capable of being carbonated and has high compatibility with copper.

5. A gravure printing roll according to any one of claims 1 to 4, wherein the metal is one kind or at least two kinds of metals selected from the group consisting of tungsten (W), silicon (Si), titanium (Ti), chromium (Cr), tantalum (Ta), and zirconium (Zr).

6. A method of producing a gravure printing roll, comprising the steps of:
preparing a hollow roll;
forming a copper-plated layer on a surface of the hollow roll;
forming multiple gravure cells and pits on a surface of the copper-plated layer;
forming a metal layer on the surface of the copper-plated layer;
forming a metal carbide layer of the metal on a surface of the metal layer; and
forming a diamond-like carbon film on a surface of the metal carbide layer,
wherein pits whose sizes are smaller than a minimum gravure cell in a highlighted portion of the copper-plated layer and does not permit transfer of ink are arranged so that at least one pit exists in a one-pitch area of a screen line in a non-image area during the formation of the gravure cells and the pits.

7. A method of producing a gravure printing roll according to claim 6, wherein the metal carbide layer is a metal carbide gradient layer, and a composition ratio of carbon in the metal carbide gradient layer is set so that a proportion of carbon increases gradually in a direction of the diamond-like carbon film from the metal layer side.

8. A method of producing a gravure printing roll according to claim 6 or 7, wherein a thickness of the copper-plated layer is 50 to 200 µm, a depth of the gravure cells is 5 to 150 µm, a thickness of the metal layer is 0.001 to 1 µm, a thickness of the metal carbide layer is 0.1 to 1 µm, and a thickness of the diamond-like carbon film is 0.1 to 10 µm.

9. A method of producing a gravure printing roll according to any one of claims 6 to 8, wherein the metal layer, the metal carbide layer, and the diamond-like carbon film are formed by sputtering, respectively.

10. A method of producing a gravure printing roll according to any one of claims 6 to 9, wherein the metal is capable of being carbonated and has high compatibility with copper.

11. A method of producing a gravure printing roll according to any one of claims 6 to 10, wherein the metal is one kind or at least two kinds of metals selected from the group consisting of tungsten (W), silicon (Si), titanium (Ti), chromium (Cr), tantalum (Ta), and zirconium (Zr).

12. A method of producing a gravure printing roll according to any one of claims 6 to 11, wherein the gravure cells and pits are formed by etching or electronic platemaking.

13. A method of producing a gravure printing roll according to any one of claims 6 to 12, comprising the steps of:
making synthetic digital information in which digital information of formation patterns of the gravure cells and digital information of arrangement patterns of the pits are superimposed; and
forming the gravure cells and pits based on the superimposed synthetic digital information.
